# EUROPÄISCHE PATENTANMELDUNG

(11) **EP 1 983 582 A2**
(43) Veröffentlichungstag der Anmeldung: **22.10.2008**
(21) Anmeldenummer: 08006498.3
(22) Anmeldetag: 31.03.2008
(51) Int. Cl.: H01L 39/14, H01L 39/24

(54) **Multifilamentsupraleiter sowie Verfahren zu dessen Herstellung**

(30) Priorität: 18.04.2007 DE 102007018269
(71) Anmelder: European Advanced Superconductors GmbH & Co. KG, 63450 Hanau (DE)
(72) Erfinder: Thöner, Manfred, Dr., 63599 Biebergmünd (DE); Ehser, Horst, 62769 Kahl (DE); Szulczyk, Andreas, 63589 Linsengericht (DE); Auer, Alfred, 63633 Birstein (DE); Abächerli, Vital, 63526 Erlensee (DE)
(74) Vertreter: Schmuckermaier, Bernhard

(57) **Zusammenfassung**

Ein Multifilamentsupraleiter (1) mit einem Kernbereich (2), der mehrere Supraleiterfilamente (7) und Verstärkungsfilamente (6) aufweist, wird vorgesehen. Die Supraleiterfilamente (7) und die Verstärkungsfilamente (6) sind so angeordnet, dass sie im Querschnitt des Kernbereichs (2) eine regelmäßige zwei-dimensionale Matrix (5) aufweisen. Die Verstärkungsfilamente (6) bestehen aus Tantal oder einer Tantallegierung und die Supraleiterfilamente (7) weisen jeweils einen Kern (8) aus einem pulvermetallurgisch hergestellten Supraleiter auf, der von einem Innenmantel (9) aus einem nicht-supraleitenden Metall oder einer nicht-supraleitenden Legierung umhüllt ist. Der Kernbereich (2) ist von einem Außenmantel (3) aus einem nicht-supraleitenden Metall oder einer nicht-supraleitenden Legierung umhüllt.

## Beschreibung

Die Erfindung betrifft einen Multifilamentsupraleiter, insbesondere einen verstärkten Multifilamentsupraleiter sowie ein Verfahren zu dessen Herstellung.

A15-Supraleiter, wie zum Beispiel Nb₃Sn kann durch verschiedene Verfahren in Form eines Drahts oder eines Bandes hergestellt werden. Bekannte Verfahren sind das so genannte Bronze-Verfahren, das Jelly-Roll-Verfahren sowie das Pulver-im-Rohr-Verfahren. A15-Supraleiter, die mittels des Pulver-im-Rohr-Verfahrens hergestellt sind, haben den Vorteil, dass sie die höchsten kritischen Stromdichten aufweisen können. Folglich eignen sich die nach dem Pulver-im-Rohr-Verfahren hergestellten Supraleiter für die Anwendung bei hochkompakten und preisgünstigen Magnetsystemen.

Die hohe Stromdichte und die dadurch erzeugte hohe Magnetfelder führen jedoch zu zunehmenden Lorentzkräften in der Magnetwicklung. Diese Lorentzkräfte können die Stromtragfähigkeit des supraleitenden Drahts der Magnetwicklung reduzieren und somit den Einsatzbereich des Pulver-im-Rohr-Drahts begrenzen.

Aufgabe der Erfindung ist es daher, einen mechanisch verstärkten Supraleiter auf Pulver-im-Rohr-Basis anzugeben, der auch für kompakte Magnetsysteme geeignet ist.

Gelöst wird diese Aufgabe durch den Gegenstand der unabhängigen Ansprüche. Vorteilhafte Weiterbildungen der Erfindung ergeben sich aus den davon abhängigen Ansprüchen.

Ein Verfahren zum Herstellen eines verstärkten Multifilamentsupraleiters weist folgende Schritte auf: Mehrere Supraleiterstäbe werden bereitgestellt, die jeweils mindestens einen pulvermetallurgischen Kern aus den Elementen eines metallischen Supraleiters aufweisen. Die pulvermetallurgischen Kerne sind jeweils von einem Innenmantel aus einem nicht-supraleitenden Metall oder einer nicht-supraleitenden Legierung umhüllt. Mehrere Verstärkungsstäbe, die jeweils aus Tantal oder einer Tantallegierung bestehen, werden bereitgestellt. Die Supraleiterstäbe und die Verstärkungsstäbe werden in einem Bündel angeordnet, und zwar derart, dass sie im Querschnitt des Bündels eine regelmäßige zwei-dimensionale Matrix bilden. Das Bündel wird mit einem Außenmantel aus einem nicht-supraleitenden Metall oder einer nicht-supraleitenden Legierung umhüllt und das umhüllte Bündel wird unter Reduzieren des Querschnitts des umhüllten Bündels spannlos verformt, um ein Multifilament zu erzeugen. Das verformte Multifilament wird bei einer Temperatur und einer Dauer geglüht, wobei die Temperatur und die Dauer der Glühung derart ausreichend ist, dass sich in den pulvermetallurgischen Kernen supraleitende Phasen ausbilden.

Durch dieses Verfahren wird ein Multifilamentsupraleiter mittels eines pulvermetallurgischen Verfahrens hergestellt, der mehrere Verstärkungsfilamente aufweist, die im Kernbereich des Multifilaments angeordnet sind. Die Verstärkungsfilamente sehen eine mechanische Verstärkung des Multifilaments vor, so dass die Fließgrenze des Multifilaments erhöht wird. Folglich wird die Fließgrenze des Multifilamentsupraleiter im Einsatz erhöht und die Stromfähigkeit des Multifilamentsupraleiters gesteigert. Der Einsatzbereich dieser mechanisch verstärkten Multifilamentsupraleiter ist somit verbreitert.

Der Außenmantel des Multifilaments kann aus Kupfer bestehen, da die mechanische Verstärkung des Multifilaments durch die im Kernbereich angeordneten Verstärkungsfilamente erfolgt. Der Außenmantel kann in einer Ausführungsform ohne Legierungszusätze zur mechanischen Verstärkung des Außenmantels ausgeführt sein. Die Anordnung mehrere Verstärkungsfilamente im Kernbereich hat den Vorteil, dass die Verstärkungsfilamente mit herkömmlichen Verfahren eingesetzt werden können. Dies kann bei der Herstellung des Bündels durch das Ersetzen einiger Supraleiterstäbe der regelmäßigen zwei-dimensionalen Matrix durch Verstärkungsstäbe erfolgen.

Der Querschnitt des umhüllten Bündels kann durch herkömmliche spanlose Verfahren reduziert werden, wobei gleichzeitig die Länge vergrößert wird, so dass ein langstreckiges Multifilament aus den gebündelten Stäben erzeugt wird. Der Querschnitt kann mittels Verfahren wie Ziehen und Hämmern gegebenenfalls mit Zwischenglühungen reduziert werden. Die Filamente des Multifilaments behalten im Wesentlichen die Anordnung der Stäbe des Bündels bei. Das Multifilament weist somit im Querschnitt eine regelmäßige zwei-dimensionale Matrix von Filamenten auf, deren Muster dem Muster der Stäbe der Bündelmatrix entspricht. In diesem Zusammenhang bezeichnet der Querschnitt den Querschnitt senkrecht zu der Länge des Multifilaments sowie senkrecht zu der Länge der Stäbe. Durch das spanlose Verformen des umhüllten Bündels durch Ziehen oder Hämmern kann ein Multifilament in Form eines Drahts oder der Gestalt eines Bandes hergestellt werden.

Verstärkungsfilamente aus Tantal oder einer Tantallegierung haben dabei den Vorteil, dass sie sich aufgrund ihres günstigen Umformwiderstands mit den anderen Komponenten des Multifilaments integrieren lassen. Dabei sind die anderen Komponenten des Multifilaments die Supraleiterfilamente sowie der Außenmantel. Gleichzeitig ist Tantal ein Metall, das bei den typischen Reaktionsbedingungen und Behandlungen zum Bilden der supraleitenden Phase seine hohen mechanischen Eigenschaften aufrechterhält. Ferner weist Tantal auch nach einer Hitzebehandlung noch bei den typischen Einsatztemperaturen im Bereich von 1.8K bis zu 10K einen extrem hohen E-Modul auf.

Der Anteil an Tantal der Verstärkungsfilamente kann eingestellt werden. Die Verstärkungsfilamente bestehen in einer Durchführungsform im Wesentlichen aus Tantal oder aus einer Tantallegierung. Bei einer weiteren Ausführungsform können die Verstärkungsstäbe jeweils einen Kern aus Tantal oder einer Tantallegierung aufweisen, der mit einem Mantel aus Cu umhüllt ist. Diese Verstärkungsstäbe können durch Strangpressen, insbesondere durch hydrostatisches Strangpressen hergestellt werden. Strangpressen ermöglicht eine gute Verbindung zwischen dem Tantalkern und dem Kupfermantel.

Die Verstärkungsstäbe können beim Bündeln in verschiedene Mustern in der Bündelmatrix angeordnet werden. In einer Durchführungsform werden beim Bilden des Bündels die Verstärkungsstäbe in der Matrix um die Supraleiterstäbe herum angeordnet. In einer weitere Ausführungsform werden die Verstärkungsstäbe nur im Randbereich der Matrix angeordnet. Die Verstärkungsstäbe bilden somit ein ringförmiges Muster um die Supraleiterstäbe herum und sind zwischen den Supraleiterstäben und dem Außenmantel angeordnet. In einer Weiterbildung sind die Verstärkungsstäbe mit einer azimutalen Symmetrie in der Matrix angeordnet. Eine azimutale symmetrische Anordnung der Verstärkungsstäbe hat den Vorteil, dass die mechanische Verstärkung gleichmäßiger über das Bündel und das Multifilament verteilt wird.

In einer weiteren Ausführungsform werden die Verstärkungsstäbe über den Querschnitt der Matrix verteilt angeordnet. Die Verstärkungsstäbe können mit Supraleiterstäben umhüllt sein. In einer Weiterbildung dieser Ausführungsform werden die Verstärkungsstäbe axial symmetrisch in der Matrix angeordnet. Diese axiale symmetrische Anordnung sieht auch eine gleichmäßigere mechanische Verstärkung des Gesamtquerschnitts des Multifilaments vor. Die symmetrische Anordnung der Verstärkungsfilamente hat den weiteren Vorteil, dass das Umformverhalten des Multifilaments optimiert wird.

Die Supraleiterstäbe und die Verstärkungsstäbe können im Wesentlichen die gleiche Querschnittsfläche aufweisen. Dies vereinfacht das Bilden des Bündels und das Bilden einer regelmäßigen zwei-dimensionalen Matrix. Bei einer weiteren Ausführungsform haben die Supraleiterstäbe sowie die Verstärkungsstäbe jeweils einen sechskantigen Querschnitt. Ein sechskantiger Querschnitt ermöglicht eine dichte Packung der Stäbe in der Matrix, damit die Stromleitfähigkeit des Multifilaments erhöht werden kann.

Der Anteil an Verstärkungsstäben kann zwischen ungefähr 10% und ungefähr 25% der Gesamtzahl der Stäbe der Matrix liegen. Dieser Anteil kann an den mechanischen Eigenschaften des Multifilaments, die für ein bestimmtes Magnetsystem erforderlich sind, angepasst werden. Die Zahl der Verstärkungsstäbe kann beliebig eingestellt werden, damit der gewünschte Anteil erreicht wird. Wenn beispielsweise die Gesamtmatrix 192 Filamente aufweist, kann die Matrix 36 Verstärkungsstäbe aufweisen, so dass das Multifilament einen Anteil an Verstärkungsstäben von ungefähr 10% aufweist. Wenn aus einer Gesamtzahl von 192 Filamenten 72 Verstärkungsstäbe sind, weist das Filament einen Verstärkungsanteil von ungefähr 20% auf.

Das Verfahren ist somit flexibel, da die mechanischen Eigenschaften des Multifilaments einfach eingestellt werden können, so dass ein Multifilament mit der gewünschten mechanischen Verstärkung vorgesehen werden kann. Die mechanischen Eigenschaften können somit an die speziellen Anforderungsprofile der Anwendung leicht angepasst werden.

Die pulvermetallurgischen Kerne der Supraleiterstäbe können jeweils die Komponente eines A15 Supraleiters aufweisen. Die pulvermetallurgischen Kerne der Supraleiterstäbe können auch jeweils Pulver aus NbTa, Nb₂Sn und Sn aufweisen, wobei aus diesen Komponenten die supraleitende Phase (Nb,Ta)₃Sn gebildet wird.

Die Supraleiterstäbe können durch ein Pulver-im-Rohr-Verfahren hergestellt werden, wobei Pulver der gewünschten Komponente in einen Kern geformt wird, der mit einem Mantel aus einem nicht-supraleitenden Metall oder aus einer nicht-supraleitenden Legierung umhüllt wird. Dieses Vorprodukt wird gegebenenfalls mit Zwischenglühungen verformt, wobei der Querschnitt reduziert und die Länge erhöht wird, um die Supraleiterstäbe herzustellen. Diese Supraleiterstäbe werden zusammen mit den Verstärkungsstäben zu einem Bündel angeordnet. Die supraleitende Phase wird nur nach dem Bündeln und nach den weiteren Verformungsschritten zum Herstellen des Multifilaments erzeugt. Zum Bilden der supraleitenden Phasen in den Kernen der Supraleiterfilamente kann eine Glühung des Multifilaments bei 500°C bis 700°C für 2 bis 20 Tage durchgeführt werden.

Ein Multifilamentsupraleiter kann auch einen Kernbereich haben, der mehrere Supraleiterfilamente und Verstärkungsfilamente aufweist. Die Supraleiterfilamente und die Verstärkungsfilamente sind dabei so angeordnet, dass sie im Querschnitt des Kernbereichs eine regelmäßige zwei-dimensionale Matrix aufweisen. Der Kernbereich ist von einem Außenmantel aus einem nicht-supraleitenden Metall oder einer nicht-supraleitenden Legierung umhüllt. Die Verstärkungsfilamente bestehen im Wesentlichen aus Tantal oder einer Tantallegierung. Die Supraleiterfilamente weisen jeweils einen Kern aus einem pulvermetallurgischen hergestellten Supraleiter auf, der von einem Innenmantel aus einem nicht-supraleitenden Metall oder einer nicht-supraleitenden Legierung umhüllt ist.

Das Multifilament ist somit auf Grund der Verstärkungsfilamente mechanisch verstärkt und kann die Gestalt eines Drahts oder die Gestalt eines Bandes aufweisen. Die Verstärkungsfilamente können beispielsweise in der Matrix um die Supraleiterfilamente herum angeordnet sein. Die Verstärkungsfilamente können auch nur im Randbereich der Matrix angeordnet sein. Beispielsweise sind die Verstärkungsfilmente azimutal symmetrisch im Randbereich in der Matrix angeordnet.

In einer weiteren Ausführungsform sind die Verstärkungsfilamente über den Querschnitt der Matrix verteilt angeordnet. Die Verstärkungsfilamente sind somit nicht nur am Rand des Kernbereichs angeordnet und können von Supraleiterfilamenten umhüllt sein. Bei einer Ausführungsform sind die Verstärkungsfilamente axial symmetrisch in der Matrix angeordnet.

Die Anordnung und das Muster der Filamente des Multifilaments entsprechen der Anordnung und dem Muster der Stäbe des Bündels, da die ursprüngliche Anordnung und das ursprüngliche Muster während des Verformens des Bündels im Wesentlichen beibehalten werden. Im Vergleich zu den Stäben weisen die Filamente einen kleineren Querschnitt und eine größere Länge auf.

Die Supraleiterfilamente und die Verstärkungsfilamente des Multifilaments können jeweils ungefähr die gleiche Querschnittsfläche aufweisen. Der Anteil an Verstärkungsfilamenten zwischen kann ungefähr 10% und ungefähr 25% der Gesamtzahl der Filamente der Matrix liegen. Bei einer Ausführungsform weisen die Supraleiterfilamente sowie die Verstärkungsfilamente jeweils einen sechskantigen Querschnitt auf.

In einer Ausführungsform weisen die Kerne der Supraleiterfilamente jeweils die Komponente eines A15 Supraleiters auf. Die Kerne der Supraleiterfilamente können jeweils die Komponenten einer (Nb,Ta)₃Sn-, Nb₃Sn-, Nb₃Al-, Nb₃Si-, Nb₃Ge-, V₃Si- oder V₃Ga-Phase oder die supraleitende (Nb,Ta)₃Sn oder Nb₃Sn oder Nb₃Al oder Nb₃Si oder Nb₃Ge oder V₃Si oder V₃Ga Phase aufweisen. Die Verstärkungsfilamente können jeweils einen Kern aus Tantal oder aus einer Tantallegierung aufweisen, der mit einem Mantel aus Kupfer umhüllt ist.

Die Erfindung wird nun anhand der beiliegenden Figuren näher erläutert.
- Figur 1: zeigt einen verstärkten Multifilamentsupraleiter nach einer ersten Ausführungsform,
- Figur 2: zeigt einen verstärkten Multifilamentsupraleiter nach einer zweiten Ausführungsform, und
- Figur 3: zeigt einen verstärkten Multifilamentsupraleiter nach einer dritten Ausführungsform.

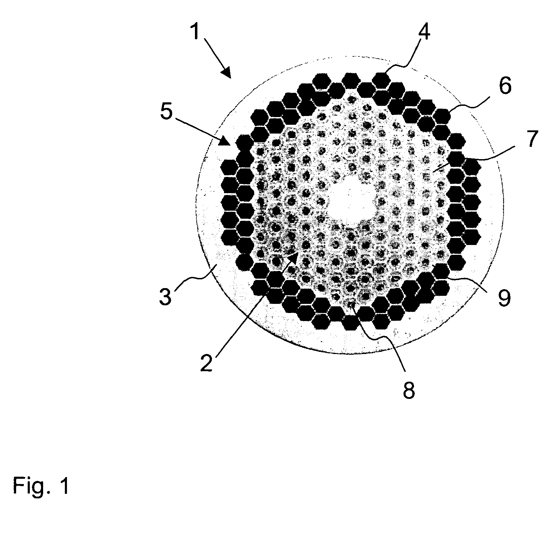

Figur 1 zeigt den Querschnitt eines mechanisch verstärkten Multifilamentsupraleiters 1 mit einem Kernbereich 2, der von einem Außenmantel 3 umhüllt ist. Der Kernbereich 2 weist 192 Filamente 4 auf. Die Filamente 4 weisen jeweils eine sechskantige Querschnittsfläche auf, die für jedes Filament ungefähr gleich ist. Die Filamente 4 sind zusammengestellt, um eine regelmäßige zwei-dimensionale hexagonale Matrix 5 zu bilden. Die äußeren Filamente 4 der Matrix 5 sind derart angeordnet, dass die Außenkante der Matrix 5 einen nahezu kreisförmigen Querschnitt aufweist.

In dieser Ausführungsform sind 72 der Gesamtzahl von 192 Filamenten 4 Verstärkungsfilamente 6. Die Verstärkungsfilamente 6 weisen jeweils einen Kern, der im Wesentlichen aus Tantal besteht, und eine Innenmantel aus Kupfer auf. Die Verstärkungsfilamente 6 wurden durch hydrostatisches Strangpressen geformt. Die Verstärkungsfilamente 6 sind in der Figur 1 schwarz dargestellt.

Die restlichen 120 der Filamente 4 sind Supraleiterfilamente 7, die in der Figur 1 grau dargestellt sind. Die Supraleiterfilamente 7 weisen jeweils einen Kern 8 aus einem pulvermetallurgischen Supraleiter auf. Die supraleitende Phase ist (Nb,Ta)₃Sn. Der Kern 8 ist von einem Innenmantel 9 aus Kupfer umhüllt. Die Supraleiterfilamente 7 wurden durch ein Pulver-im-Rohr-Verfahren hergestellt.

Die Verstärkungsfilamente 6 sind im äußeren Bereich des Kernbereichs angeordnet und sind um die Supraleiterfilamente 7 herum angeordnet. Die Verstärkungsfilamente 6 sind in der Matrix 5 mit einer azimutalen Symmetrie angeordnet, damit die mechanische Verstärkung gleichmäßig über den Querschnitt des Multifilaments 1 verteilt ist.

In dieser Ausführungsform weist der innere zentrale Bereich des Kernbereichs keine Supraleiterfilamente 7 oder Verstärkungsfilamente 6 auf und weist stattdessen Kupfer auf.

Zum Herstellen des Multifilaments 1 wurden zunächst mehrere Supraleiterstäbe und Verstärkungsstäbe hergestellt. Zum Herstellen der Supraleiterstäbe wurden Pulver der Komponenten der supraleitenden Phase zu einem Stab geformt und mit einem Kupfermantel umhüllt. Der Querschnitt wurde durch Ziehen reduziert, um sechskantige Supraleiterstäbe zu formen. Mehrere Verstärkungsstäbe wurde durch hydrostatisches Strangpressen des mit Kupfer umhüllten Tantalkerns hergestellt. Die Verstärkungsstäbe weisen auch eine sechskantige Form auf. Die Querschnittsfläche der Supraleiterstäbe und der Verstärkungsstäbe ist ungefähr gleich.

Die Längsseiten der Supraleiterstäbe und der Verstärkungsstäbe wurden zusammengestellt und zu einem Bündel angeordnet, das im Querschnitt eine regelmäßige hexagonale Matrix aufweist. Die Verstärkungsstäbe werden in der Matrix angeordnet, so dass die Matrix das gewünschte Muster von Verstärkungsstäben und Supraleiterstäben aufweist. Das Bündel wurde mit einem Außenmantel aus Kupfer umhüllt und das umhüllte Bündel mittels Ziehen und Zwischenglühen verformt, wobei der Querschnitt reduziert, die Länge erhöht und ein Multifilament 1 hergestellt wird. Die Anordnung der Supraleiterfilamente 7 und der Verstärkungsfilmante 6 in der Matrix 5 des hergestellten Multifilaments 1 entspricht der Anordnung der Stäbe im Bündel. Anschließend wurde das Multifilament 1 bei 500°C bis 700°C für 2 bis 20 Tage geglüht, so dass sich in den pulvermetallurgischen Kernen 8 die supraleitende Phase aus dem Pulver gebildet hat.

Die zweite und dritte Ausführungsform des Multifilamentsupraleiters unterscheiden sich von der ersten Ausführungsform der Figur 1 durch die Zahl der Verstärkungsfilamente 6 und ihre Anordnung innerhalb der Matrix 5. Die Anordnung der Verstärkungsfilamente 6 und die der Supraleiterfilamente 7 der Matrix 5 wurde durch die Anordnung der Stäbe beim Bündeln bestimmt.

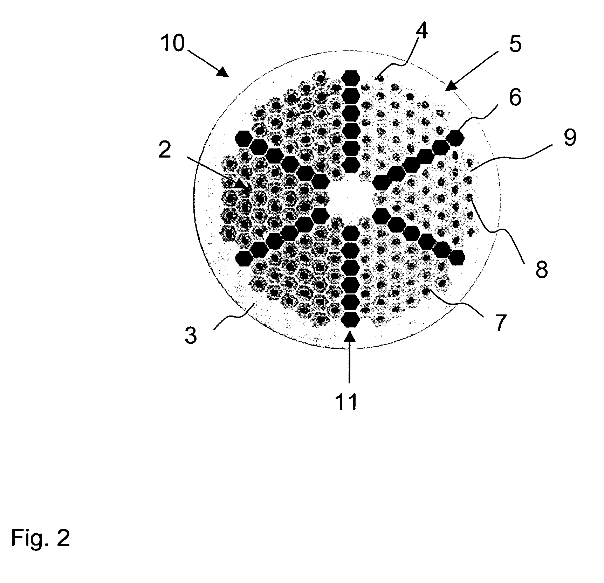

Figur 2 zeigt einen Querschnitt eines Multifilamentsupraleiters 10 nach einer zweiten Ausführungsform. Dieser zweite Multifilamentsupraleiter 10 weist auch 192 sechskantige Filamente 4 auf, die in einer Matrix 5 mit einem hexagonalen Muster wie in der Figur 1 zusammen angeordnet sind. In der zweiten Ausführungsform sind 36 Filamente 4 der 192 Filamente Verstärkungsfilamente 6. Der Verstärkungsanteil liegt somit bei 18%. Im Gegensatz zu der in der Figur 1 dargestellten ersten Ausführungsform sind die Verstärkungsfilamente 6 nicht nur im Randbereich der Matrix 5 angeordnet sondern über die gesamte Matrix 5 verteilt. In dieser Ausführungsform sind die Verstärkungsfilamente 6 mit einer radialen Symmetrie in der Matrix 5 angeordnet. Dazu sind sechs Reihen 11 von Verstärkungsfilamente 6, die jeweils sechs Verstärkungsfilamente 6 aufweisen, vorgesehen. Die sechs Reihen 11 sind radial symmetrisch in der Matrix 5 angeordnet. Die Winkel zwischen den benachbarten Reihen 11 sind somit ungefähr 60°.

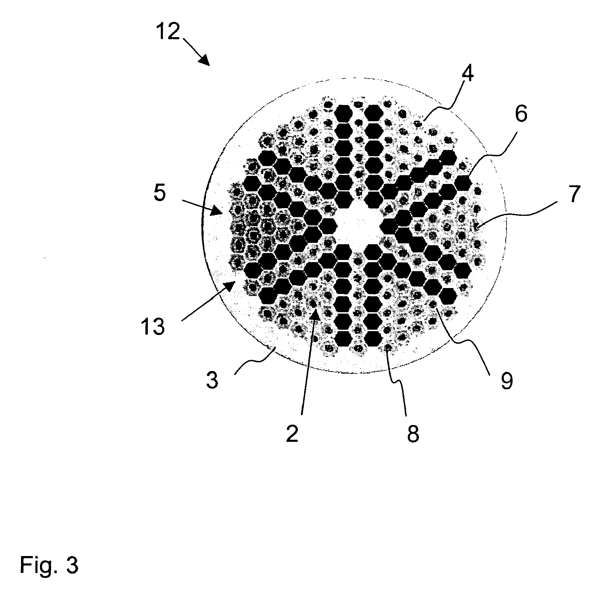

Die Figur 3 zeigt ein Multifilamentsupraleiter 12 nach einer dritten Ausführungsform. Der dritte Multifilamentsupraleiter 12 weist ebenfalls einen Kernbereich mit 192 Filamenten auf, die in einer hexagonal Matrix 5 angeordnet sind. In der dritten Ausführungsform sind 66 der 192 Filamente 4 Verstärkungsfilamente 6. Der dritte Multifilamentsupraleiter 12 weist einen Verstärkungsanteil von 20% auf.

Die Verstärkungsfilamente 6 sind mit einer radialen Symmetrie in der Matrix 5 angeordnet. Dazu sind sechs V-förmige Anordnungen 13 vorgesehen, die jeweils elf Verstärkungsfilamente 6 aufweisen. Die Spitze der V-Form 13 ist nach Innen ausgerichtet, so dass die Winkel zweier benachbarter V-Formen ungefähr bei 60° liegt. Die Seite der V-Formen 13 sind parallel zu der Seite der benachbarten V-Form angeordnet, wobei jeweils eine Reihe von Supraleiterfilamenten 7 zwischen benachbarten V-Formen 13 angeordnet ist.

Die Multifilamante 1, 10, 12 können zum Herstellen einer Magnetwicklung verwendet werden. Durch die Verstärkungsfilamente 6 sind die Multifilamente 1, 10, 12 mechanisch derart verstärkt, dass die Fließgrenze des Multifilaments 1, 10, 12 erhöht wird. Dies führt zu einer verbesserten Stromtragfähigkeit, da der Einfluss der Lorentzkraft reduziert wird. Der Einsatz dieser Multifilamente mit pulvermetallurgischen Kernen wird somit verbreitert.

### Bezugszeichenliste

- 1: Erstes Multifilament
- 2: Kernbereich
- 3: Außenmantel
- 4: Filament
- 5: Matrix
- 6: Verstärkungsfilament
- 7: Supraleiterfilament
- 8: Kern des Supraleiterfilaments
- 9: Innenmantel des Supraleiterfilaments
- 10: Zweites Multifilament
- 11: Reihe von Verstärkungsfilamenten
- 12: Drittes Multifilament
- 13: V-Form der Verstärkungsfilamente

## Patentansprüche

1. Verfahren zum Herstellen eines verstärkten Multifilamentsupraleiters (1), das folgende Schritte aufweist:
- Bereitstellen mehrerer Supraleiterstäbe (7), die jeweils mindestens einen pulvermetallurgischen Kern (8) aus den Elementen eines metallischen Supraleiters aufweisen, wobei der Kern (8) von einem Innenmantel (9) aus einem nicht-supraleitenden Metall oder einer nicht-supraleitenden Legierung umhüllt ist,
- Bereitstellen mehrerer Verstärkungsstäbe (6), die jeweils aus Tantal oder einer Tantallegierung bestehen,
- Anordnen der Supraleiterstäbe (7) und der Verstärkungsstäbe (6) zu einem Bündel, wobei die Supraleiterstäbe (7) und die Verstärkungsstäbe (6) so angeordnet werden, dass sie im Querschnitt des Bündels eine regelmäßige zwei-dimensionale Matrix (5) bilden,
- Umhüllen des Bündels mit einem Außenmantel (3) aus einem nicht-supraleitenden Metall oder einer nicht-supraleitenden Legierung,
- Verformen des umhüllten Bündels unter reduzieren des Querschnitts des umhüllten Bündels zum Erzeugen eines Multifilaments (1),
- Glühen des verformten Multifilaments (1) bei einer Temperatur und einer Dauer, die ausreichend ist, dass sich in dem pulvermetallurgischen Kernen (8) supraleitende Phasen ausbilden.

2. Verfahren nach Anspruch 1,
**dadurch gekennzeichnet, dass**
zum Bilden des Bündels die Verstärkungsstäbe (6) in der Matrix (5) um die Supraleiterstäbe (7) herum angeordnet werden.

3. Verfahren nach Anspruch 1 oder Anspruch 2,
**dadurch gekennzeichnet, dass**
die Verstärkungsstäbe (6) nur im Randbereich der Matrix (5) angeordnet werden

4. Verfahren nach einem der Ansprüche 1 bis 3,
**dadurch gekennzeichnet, dass**
die Verstärkungsstäbe (6) mit einer azimutale Symmetrie in der Matrix (5) angeordnet werden.

5. Verfahren nach Anspruch 1,
**dadurch gekennzeichnet, dass**
die Verstärkungsstäbe (6) über den Querschnitt der Matrix (5) verteilt angeordnet werden.

6. Verfahren nach Anspruch 5,
**dadurch gekennzeichnet, dass**
die Verstärkungsstäbe (6) mit einer axiale Symmetrie in der Matrix (5) angeordnet werden.

7. Verfahren nach einem der vorhergehenden Ansprüche,
**dadurch gekennzeichnet, dass**
die Supraleiterstäbe (7) und die Verstärkungsstäbe (6) im Wesentlichen die gleiche Querschnittsfläche aufweisen.

8. Verfahren nach einem der vorhergehenden Ansprüche,
**dadurch gekennzeichnet, dass**
die Supraleiterstäbe (7) sowie die Verstärkungsstäbe (6) jeweils einen sechskantigen Querschnitt aufweisen.

9. Verfahren nach einem der vorhergehenden Ansprüche,
**dadurch gekennzeichnet, dass**
der Anteil an Verstärkungsstäbe (6) zwischen ungefähr 10% und ungefähr 25 % der Gesamtzahl der Stäbe der Matrix (5) liegt.

10. Verfahren nach einem der vorhergehenden Ansprüche,
**dadurch gekennzeichnet, dass**
die pulvermetallurgischen Kerne (8) der Supraleiterstäbe (7) jeweils die Komponente eines A15 Supraleiters aufweisen.

11. Verfahren nach einem der vorhergehenden Ansprüche,
**dadurch gekennzeichnet, dass**
die pulvermetallurgische Kerne (8) der Supraleiterstäbe (7) jeweils Pulver aus NbTa, Nb₂Sn und Sn aufweisen.

12. Verfahren nach einem der vorhergehenden Ansprüche,
**dadurch gekennzeichnet, dass**
die Glühung bei 500°C bis 700°C für 2 bis 20 Tage durchgeführt wird.

13. Verfahren nach einem der vorhergehenden Ansprüche,
**dadurch gekennzeichnet, dass**
die Verstärkungsstäbe (6) jeweils einen Kern aus Tantal oder einer Tantallegierung aufweisen, der mit einem Mantel aus Cu umhüllt ist.

14. Verfahren nach einem der vorhergehenden Ansprüche,
**dadurch gekennzeichnet, dass**
die Verstärkungsstäbe (6) durch Strangpressen hergestellt werden.

15. Verfahren nach einem der vorhergehenden Ansprüche,
**dadurch gekennzeichnet, dass**
die Supraleiterstäbe (7) durch ein Pulver-im-Rohr-Verfahren hergestellt werden.

16. Verfahren nach einem der vorhergehenden Ansprüche,
**dadurch gekennzeichnet, dass**
durch das spanlose Verformen des umhüllten Bündels das Multifilament mit der Gestalt eines Drahts oder der Gestalt eines Bandes erzeugt wird.

17. Multifilamentsupraleiter (1) mit einem Kernbereich (2), der mehrere Supraleiterfilamente (7) und Verstärkungsfilamente (6) aufweist, wobei die Supraleiterfilamente (7) und die Verstärkungsfilamente (6) so angeordnet sind, dass sie im Querschnitt des Kernbereichs (2) eine regelmäßige zwei-dimensionale Matrix (5) aufweisen, und wobei der Kernbereich (2) von einem Außenmantel (3) aus einem nicht-supraleitenden Metall oder einer nicht-supraleitenden Legierung umhüllt ist,
**dadurch gekennzeichnet, dass**
die Verstärkungsfilamente (6) aus Tantal oder einer Tantallegierung bestehen und die Supraleiterfilamente (7) jeweils einen Kern (8) aus einem pulvermetallurgischen hergestellten Supraleiter aufweisen, der von einem Innenmantel (9) aus einem nicht supraleitenden Metall oder einer nicht supraleitenden Legierung umhüllt ist.

18. Multifilamentsupraleiter (1) nach Anspruch 17,
**dadurch gekennzeichnet, dass**
das Multifilamentsupraleiter (1) die Gestalt eines Drahts oder eines Bandes aufweist.

19. Multifilamentsupraleiter (1) nach Anspruch 17 oder Anspruch 18,
**dadurch gekennzeichnet, dass**
die Verstärkungsfilamente (6) in der Matrix (5) um die Supraleiterfilamente (7) herum angeordnet sind.

20. Multifilamentsupraleiter (1) nach einem der Ansprüche 17 bis 20,
**dadurch gekennzeichnet, dass**
die Verstärkungsfilamente (6) nur im Randbereich der Matrix (5) angeordnet sind.

21. Multifilamentsupraleiter (1) nach einem der Ansprüche 17 bis 20,
**dadurch gekennzeichnet, dass**
die Verstärkungsfilmente (6) mit einer azimutalen Symmetrie in der Matrix (5) angeordnet sind.

22. Multifilamentsupraleiter (1) nach einem der Ansprüche 17 bis 19,
**dadurch gekennzeichnet, dass**
die Verstärkungsfilamente (6) über den Querschnitt der Matrix (5) verteilt angeordnet sind.

23. Multifilamentsupraleiter (1) nach Anspruch 22,
**dadurch gekennzeichnet, dass**
die Verstärkungsfilamente (6) mit einer axialen Symmetrie in der Matrix (5) angeordnet sind.

24. Multifilamentsupraleiter (1) nach einem der Ansprüche 17 bis 23,
**dadurch gekennzeichnet, dass**
die Supraleiterfilamente (7) und die Verstärkungsfilamente (6) jeweils ungefähr die gleiche Querschnittsfläche aufweisen.

25. Multifilamentsupraleiter (1) nach Anspruch 24,
**dadurch gekennzeichnet, dass**
der Anteil an Verstärkungsfilamente (6) zwischen ungefähr 10% und ungefähr 25 % der Gesamtzahl der Filamente der Matrix liegt.

26. Multifilamentsupraleiter (1) nach einem der Ansprüche 17 bis 25,
**dadurch gekennzeichnet, dass**
die Supraleiterfilamente (7) sowie die Verstärkungsfilamente (6) jeweils einen sechskantigen Querschnitt aufweisen.

27. Multifilamentsupraleiter (1) nach einem der Ansprüche 17 bis 26,
**dadurch gekennzeichnet, dass**
die Kerne (8) der Supraleiterfilamente (7) jeweils die Komponente eines A15 Supraleiters aufweisen.

28. Multifilamentsupraleiter (1) nach Anspruch 27,
**dadurch gekennzeichnet, dass**
die Kerne (8) der Supraleiterfilamente (7) jeweils (Nb,Ta)₃Sn oder Nb₃Sn oder Nb₃Al oder Nb₃Si oder Nb₃Ge oder V₃Si oder V₃Ga aufweisen.

29. Multifilamentsupraleiter (1) nach einem der Ansprüche 17 bis 28,
**dadurch gekennzeichnet, dass**
die Verstärkungsfilamente (6) jeweils einen Kern aus Tantal oder aus einer Tantallegierung aufweisen, der mit einem Mantel aus Kupfer umhüllt ist.
